Europäisches Patentamt

European Patent Office

Office européen des brevets

(19)

(11) **EP 1 344 075 B1**

(12) **FASCICULE DE BREVET EUROPEEN**

(45) Date de publication et mention
de la délivrance du brevet:
**31.08.2005 Bulletin 2005/35**

(21) Numéro de dépôt: **01978551.8**

(22) Date de dépôt: **17.10.2001**

(51) Int Cl.$^7$: **G01R 33/26**

(86) Numéro de dépôt international:
**PCT/FR2001/003212**

(87) Numéro de publication internationale:
**WO 2002/033434 (25.04.2002 Gazette 2002/17)**

(54) **MESURE VECTORIELLE D'UN CHAMP MAGNETIQUE**

VEKTORIELLE MAGNETFELDMESSUNG

VECTOR MEASUREMENT OF A MAGNETIC FIELD

(84) Etats contractants désignés:
**AT BE CH CY DE DK ES FI FR GB GR IE IT LI LU MC NL PT SE TR**

(30) Priorité: **18.10.2000 FR 0013328**

(43) Date de publication de la demande:
**17.09.2003 Bulletin 2003/38**

(73) Titulaire: **COMMISSARIAT A L'ENERGIE ATOMIQUE**
**75752 Paris Cédex 15 (FR)**

(72) Inventeurs:
• **LEGER, Jean-Michel**
**F-38190 Villard Bonnot (FR)**
• **GRAVRAND, Olivier**
**F-38000 Grenoble (FR)**
• **BERTRAND, François**
**F-38700 La Tronche (FR)**

(74) Mandataire: **Poulin, Gérard**
**Société BREVATOME**
**3, rue du Docteur Lancereaux**
**75008 Paris (FR)**

(56) Documents cités:
EP-A- 0 964 260     FR-A- 1 354 208
FR-A- 2 155 981     FR-A- 2 663 431
US-A- 3 828 243

## Description

### Domaine technique

La présente invention a pour objet un dispositif et un procédé de mesure des composantes d'un champ magnétique à l'aide d'un magnétomètre scalaire. Elle trouve une application dans la mesure des champs magnétiques faibles (de l'ordre de grandeur du champ magnétique terrestre, soit quelques dizaines de microteslas) que l'on veut obtenir avec une grande précision, de l'ordre de $10^{-5}$.

### Etat de la technique antérieure

Depuis de nombreuses années des travaux ont été consacrés à la mesure vectorielle de champs magnétiques à partir de magnétomètres intrinsèquement scalaires, c'est-à-dire sensibles uniquement au module du champ magnétique, indépendamment de sa direction. L'idée sous-jacente de ces travaux est de tirer parti du caractère absolu des mesures scalaires (basées sur la résonance de protons (RMN) ou d'électrons (RPE)) pour pallier l'un des défauts majeurs des capteurs vectoriels, à savoir leur décalage ("offsets") et les dérives basse fréquence associées.

Une telle réalisation est décrite par exemple dans le brevet FR-A-2 663 751 ou dans son correspondant américain US-A-5,221,897. Ces documents contiennent en outre des références bibliographiques sur le sujet.

Un magnétomètre vectoriel utilisant un tel magnétomètre scalaire et capable de délivrer les valeurs de chacune des composantes du vecteur champ magnétique dont le module est délivré par le magnétomètre scalaire est décrit dans la demande de brevet EP-A-0 964 260.

Selon l'invention décrite dans cette demande le dispositif de mesure des composantes du champ magnétique comprend outre un magnétomètre scalaire délivrant un signal de sortie correspondant au module d'un champ magnétique appliqué :

- au moins deux enroulements conducteurs disposés autour dudit magnétomètre scalaire, ces enroulements conducteurs ayant des axes orientés dans des directions différentes (Ox, Oy, Oz),
- des moyens pour alimenter chaque enroulement par un courant ayant une fréquence déterminée (Fx, Fy, Fz) propre à cet enroulement,

des moyens de traitement recevant le signal délivré par le magnétomètre scalaire, ces moyens étant aptes à effectuer des démodulations synchrones, au moins aux fréquences (Fx, Fy, Fz) des courants d'alimentation des enroulements, ces moyens de traitement délivrant, pour chaque fréquence, un signal correspondant à la composante (Bx, By, Bz) du champ magnétique appliqué selon l'axe (Ox, Oy, Oz) de l'enroulement alimenté à cette fréquence.

L'analyse du signal induit par chacun des enroulements permet de retrouver la composante du vecteur champ magnétique de module $B_0$ projetée sur cet axe.

Par ailleurs un article de J. M. G. MERAYO, F. PRIMDAHL ET P. BRAUER remis le 21 janvier 2000 aux participants au premier "Workshop for calibration of the magnetic field of the earth" tenu à Saclay (1) et intitulé "l'orthogonalisation des systèmes magnétiques" explique comment passer d'un système axial réel en principe orthonormé mais nécessairement biaisé, c'est-à-dire orthonormé ou proche d'un système orthonormé à un système d'axes reconstruit réellement orthonormé, et comment recalculer les composantes d'un vecteur champ magnétique dans le système d'axes orthonormé reconstruit à partir des mesures obtenues sur les axes magnétiques des bobines. Un dispositif apte à effectuer un tel changement d'axes peut comporter outre les moyens de calcul des matrices de changement d'axes, des capteurs dédiés à cette fonction. Le calcul peut aussi être effectué à partir des détections effectuées par chacune des deux autres bobines d'un champ émis par l'une des bobines.

### Brève description de l'invention

Des études menées par l'inventeur ont révélé la présence d'un résidu, c'est-à-dire d'une différence non nulle, entre la mesure directe de la valeur du module du vecteur champ magnétique obtenue par le magnétomètre scalaire et la valeur calculée de ce module à partir de ses trois composantes, obtenues elles, par démodulation synchrone à chacune des fréquences de modulation du champ.

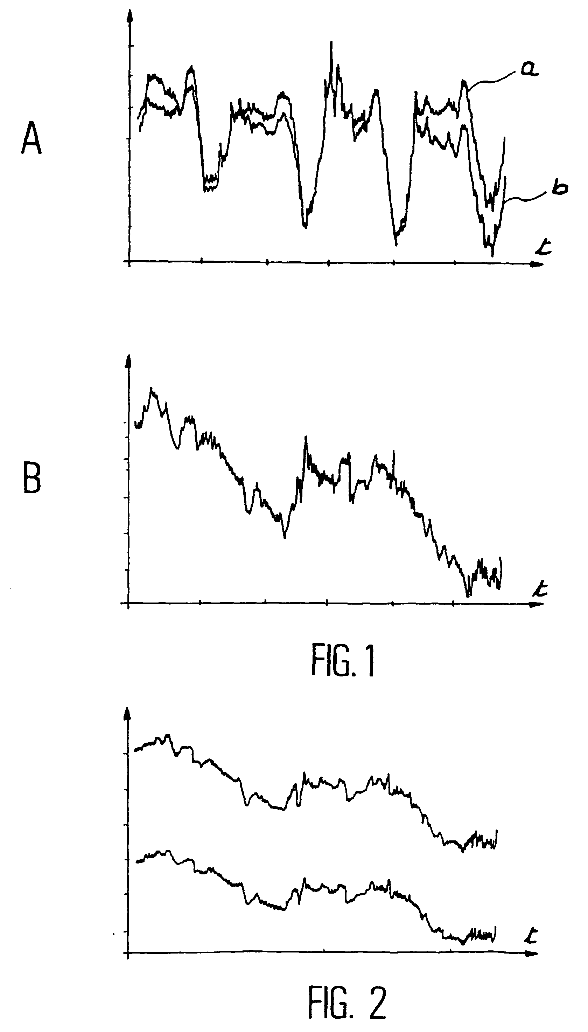

La figure 1 partie A, représente deux courbes. Une première courbe repérée a représente l'évolution dans le temps de la valeur du module du vecteur champ magnétique obtenue à partir du capteur scalaire. Une seconde courbe en traits pleins repérée b représente l'évolution dans le même temps de la valeur de ce module calculée à partir de ses trois composantes obtenues par l'analyse des signaux en provenance de chacun des trois enroulements.

La figure 1 partie B représente à une échelle agrandie pour les ordonnées, l'évolution dans le même temps de la différence dB entre les valeurs des modules obtenues par mesure directe et par calcul.

Sur cette figure les ordonnées sont graduées en nT et font apparaître une différence variant entre - 15nT et + 10nT. Il en est conclu que la mesure des composantes selon la méthode connue de l'art antérieure ne permet pas d'atteindre des précisions de l'ordre de $10^{-5}$ et qu'il convient donc d'améliorer le dispositif et la méthode de mesure pour atteindre cet objectif.

L'invention a donc pour objet un dispositif et un procédé de mesure des composantes d'un champ magnétique à $10^{-5}$ près.

L'hypothèse retenue pour l'amélioration du procédé connu décrit dans la demande de brevet EP-A-0 964 260 précitée, est que la fonction de transfert $f_{transfert}$ permettant de passer de la mesure à une fréquence par exemple Fx selon l'axe Ox à la composante du champ selon cette direction Ox, est égale au produit d'une fonction de ladite fréquence Fx par une fonction dépendant de l'instrument de mesure employé et qui sera notée $f_{instrumental}$.

La raison de cette hypothèse est la suivante. Le fonctionnement en mode vectoriel repose sur l'analyse de la réponse du magnétomètre scalaire à une stimulation selon un mode périodique à chacune des fréquences Fx, Fy, et éventuellement Fz. Il en résulte que toute modification de bande passante du magnétomètre scalaire affectera les fonctions de transfert préalablement déterminées, d'une façon qui n'est plus négligeable lorsqu'on cherche une précision de l'ordre de $10^{-5}$.

La bande passante est une résultante des différents phénomènes physiques mis en oeuvre dans la sonde scalaire. Pour un magnétomètre scalaire à pompage optique à hélium conforme au document FR-A-2 713 347 déjà cité (ou son correspondant américain US-A-5,534,776), elle dépend notamment du temps de relaxation des atomes dans le niveau métastable qui varie avec la température T proportionnellement à $1/\sqrt{T}$ et avec l'intensité du champ électrique haute fréquence d'entretien de la décharge, du temps de pompage qui dépend de l'intensité du faisceau laser, ou encore de la constante de temps caractéristique de la résonance magnétique qui est une fonction du champ radiofréquence.

Ainsi selon l'invention on admet que :

$$f_{instrumental} * H(F) = f_{transfert}$$

La fonction instrumentale $f_{instrumental}$ qui dépend des caractéristiques connues de l'instrument est connue à $10^{-5}$ près. Il reste selon l'invention à déterminer pour chaque fréquence Fx, ou Fy ou Fz la fonction de transfert H(F).

Si l'on considère en première approximation que la bande passante du capteur scalaire s'apparente à un filtre passe bas du premier ordre :

$$H(F) = \frac{1}{1 + i\frac{F}{F_0}}$$

où $F_0$ est la fréquence de coupure du filtre.

Le module de cette fonction de transfert s'écrit :

$$\left| H(F) \right| = \frac{1}{\sqrt{1 + \left(\dfrac{F}{F_0}\right)^2}}$$

Dans le cas d'une fréquence petite devant la fréquence de coupure de ce filtre, on développe le module au second ordre :

$$\left| H(F) \right|_{F \ll F_0} \cong 1 - \frac{1}{2}\left(\frac{F}{F_0}\right)^2 + o\left(\frac{F_0}{F}\right)^4$$

d'où une fluctuation relative proportionnelle aux fluctuations relatives de $F_o$ :

$$\frac{\Delta|H|}{|H|} \underset{F<<F_0}{\cong} \frac{\left(\frac{F}{F_0}\right)^2}{1-\frac{1}{2}\left(\frac{F}{F_0}\right)^2} \frac{\Delta F_0}{F_0} \underset{F<<F_0}{\cong} \left(\frac{F}{F_0}\right)^2 \frac{\Delta F}{F_0} \quad (4)$$

Les fluctuations des fonctions de transfert sont donc proportionnelles à celles de la bande passante du capteur scalaire hélium, le facteur de proportionnalité dépendant de $F^2$. En conséquence, le résidu scalaire varie alors proportionnellement à la fluctuation de la bande passante :

$$\Delta(dB_a) \cong \Delta\left(\sqrt{\sum_{i=x.y.z}\left(H(F_i)\frac{B_0 H_{li}}{b_{mi}}\right)^2}\right) \cong 2 \frac{\sum_{i=x.y.z}\frac{B_0 H_{li}}{b_{mi}} H(F_i)\left(\frac{F_{li}}{F_0}\right)^2 1}{\sqrt{\sum_{i=x.y.z}\left(H(F)\frac{B_0 H_{li}}{b_{mi}}\right)^2}} \frac{\Delta F_0}{F_0}$$

Par ailleurs, la phase de ce filtre est donnée par l'expression :

$$\varphi(F) = -\arctan\left(\frac{F}{Fo}\right)$$

Pour une fréquence proche du continu, on peut écrire :

$$\varphi(F) = -\frac{F}{Fo} + o\left(\frac{F}{F_0}\right)^3$$

Pour $F<<F_o$, on en déduit qu'une fluctuation $\Delta F_o$ de la bande du capteur scalaire se traduit alors par une fluctuation $\Delta\varphi$ de la phase telle que :

$$\frac{\Delta\varphi}{\varphi} \underset{F<<F_0}{\cong} -\frac{\Delta F_0}{F_0}$$

En examinant les évolutions parallèles du résidu scalaire dB et des phases des harmoniques (la troisième projection étant dans la configuration expérimentale retenue presque nulle, la phase du signal correspondant n'a pas été représentée) lors de l'enregistrement présenté en figure 2 on constate que les phases $\varphi_x$, $\varphi_y$ des deux composantes X et y fluctuent de manière corrélée avec les évolutions de dB, représenté figure 1B conformément aux résultats de la modélisation.

La méthode proposée consiste à prendre en compte les fluctuations de la bande passante du magnétomètre scalaire en exploitant l'information contenue dans les phases des signaux générés par une ou plusieurs des modulations.

Par contre, au lieu d'une simple détection synchrone pour chaque modulation comme dans la demande FR 98 07216 déjà citée on réalise une double détection synchrone en phase et en quadrature ce qui permet la détection simultanée de l'amplitude M et de la phase $\varphi$ de chaque signal en fonction des modules en phase P et en quadrature

Q, M = $(P^2 + Q^2)^{1/2}$ et $\varphi$ = Arct(Q/P).

La mesure de phase permet une estimation de la fréquence de coupure $F_0$ du magnétomètre qui est ensuite exploitée pour corriger le module de la fonction de transfert |H(F)| à la fréquence considérée.

Ainsi un dispositif de mesure des composantes du champ magnétique, amélioré selon l'invention, comprendra tous les éléments décrits en relation avec la demande de brevet FR 98 07 216 déjà citée, mais l'un au moins des moyens pour appliquer à l'un au moins des enroulements Ex, Ey, et Ez , un premier signal seront modifiés pour générer un second signal à la même fréquence mais déphasé par rapport à l'autre. Le premier signal sera comme dans l'art antérieur appliqué aux enroulement Ex, Ey, et Ez.

Les moyens de détection associés à chacun des enroulements seront aptes à effectuer non seulement la détection en phase comme dans l'art antérieur, mais aussi conformément à l'invention, une détection en quadrature. A cette fin ils recevront les seconds signaux déphasés par rapport aux premiers signaux. Les moyens de calcul comprendront, conformément à l'invention des moyens de calcul de la phase de la fonction de transfert du magnétomètre scalaire pour au moins l'une des fréquences appliquée à un enroulement, et du module de cette fonction.

En résumé l'invention est relative à un dispositif de mesure précise des composantes du champ magnétique utilisant un magnétomètre scalaire délivrant un signal de sortie correspondant au module d'un champ magnétique appliqué et comportant :

- au moins deux enroulements conducteurs disposés autour dudit magnétomètre scalaire, ces enroulements conducteurs ayant des axes orientés dans des directions différentes (Ox, Oy, Oz),
- des moyens pour alimenter chaque enroulement par un courant ayant une fréquence déterminée (Fx, Fy, Fz) propre à cet enroulement,
- des moyens de traitement recevant le signal délivré par le magnétomètre scalaire, et traitant ce signal pour en déduire une valeur de la composante continue selon chacun des axes des enroulements,

dispositif caractérisé en ce que au moins l'un des moyens pour alimenter chaque enroulement par un courant ayant une fréquence déterminée (Fx, Fy, Fz) propre à cet enroulement, produit à cette fréquence des signaux en phase et en quadrature, en ce que les moyens de traitement recevant le signal délivré par le magnétomètre scalaire, sont aptes à effectuer outre une démodulation synchrone en phase au moins aux fréquences (Fx, Fy, Fz) d'alimentation des enroulements, une démodulation en quadrature pour au moins l'une des fréquences (Fx, Fy, Fz) des courants d'alimentation des enroulements (Ex, Ey, Ez), ces moyens de démodulation recevant outre le signal en phase généré par l'alimentation des enroulements (Ex, Ey, Ez) le signal en quadrature en provenance des moyens de génération (Gx, Gy, Gz), et enfin en ce que ces moyens de traitement comprennent un module de calcul calculant de façon directe ou indirecte à partir des résultats des différentes démodulations, pour chaque fréquence, au moins une fonction de transfert du magnétomètre pour l'une des fréquences délivrées par les moyens pour alimenter chaque enroulement par un courant ayant une fréquence déterminée propre à cet enroulement, et corrigeant la valeur du module de chaque comparante par application de la fonction de transfert calculée de façon directe ou indirecte.

Dans la pratique on pourra modifier un dispositif selon l'art antérieur en adjoignant à l'un au moins des générateurs (Gx, Gy, Gz) pour alimenter chaque enroulement par un courant ayant une fréquence déterminée (Fx, Fy, Fz) propre à cet enroulement, un retard quart d'onde. Ainsi un enroulement Ex par exemple sera alimenté par une sortie directe du générateur. Par contre les moyens de démodulations recevront outre la sortie directe, une sortie parallèle en quadrature.

Les logiciels des moyens de traitement seront modifiés pour d'une part effectuer une double démodulation synchrone, en phase et en quadrature, sur au moins l'une des fréquences spécifiques de chaque axe et calculer une correction de la valeur de la composante continue selon chacun des axes prenant en compte les résultats de cette double démodulation.

Dans un mode de réalisation il y a un enroulement pour chaque axe, et trois générateurs $G_x$, $G_y$, $G_z$. Ces trois générateurs sont munis chacun d'un retard quart d'onde. Chacun des trois générateurs est couplé à un enroulement et à un démodulateur effectuant une démodulation en phase. Chacun des retards est couplé à un démodulateur effectuant une démodulation en quadrature.

Il est possible aussi de n'utiliser que deux retards quart d'onde, et de calculer la fonction de transfert uniquement pour les fréquences alimentant respectivement l'enroulement $E_x$, et l'enroulement $E_Y$, la fonction de transfert pour la troisième composante étant obtenues de façon indirecte à partir de l'une des deux fonctions de transfert obtenues de façon directe, de préférence celle dont le module est le plus grand.

L'invention concerne aussi un procédé de mesure de composantes d'un champ magnétique selon des axes (Ox, Oy, Oz), orientés dans des directions différentes, obtenues à partir d'un dispositif utilisant un magnétomètre scalaire délivrant un signal de sortie correspondant au module $B_0$ d'un champ magnétique appliqué, le procédé consistant à superposer au champ magnétique à mesurer, des champs orientés chacun selon chacun des axes (Ox, Oy, Oz) respectivement, ces champs superposés variant dans le temps de façon périodique selon une fréquence (Fx, Fy, Fz) spécifique à chaque axe, puis à démoduler de façon synchrone à chacune des fréquences (Fx, Fy, Fz) le signal issu du magnétomètre scalaire et à traiter le signal résultant d'une démodulation synchrone à une fréquence, pour en déduire la valeur de la composante continue du champ magnétique selon l'axe recevant le champ superposé à cette fréquence, procédé caractérisé en ce que pour l'une au moins des directions axiales la démodulation est effectuée de façon synchrone en phase et en quadrature pour l'un au moins des champs superposés et en ce que on calcule directement à partir des résultats de démodulation au moins une fonction de transfert du magnétomètre pour l'une des fréquences à laquelle on a effectué une superposition d'un champ périodique à cette fréquence, et éventuellement de façon indirecte une ou deux fonctions de transfert à partir d'une fonction de transfert obtenue directement et en ce que l'on corrige la valeur du module de chaque composante par application de l'une des fonction de transfert calculées de façon directe ou indirecte.

Ainsi de façon générale on calculera une fonction de transfert de façon directe ou indirecte à chacune des fréquences, et on corrigera chaque composante en fonction de la fonction de transfert calculée à la fréquence correspondant à cette composante.

Selon un mode de réalisation du procédé :

- on calcule les composantes non corrigées du champ magnétique,
- on effectue une comparaison entre les composantes pour déterminer la plus grande,
- on effectue la correction en appliquant à chaque composante axiale la fonction de transfert correspondant à la fréquence de modulation appliquée à l'enroulement selon l'axe de cette composante axiale, la fonction de transfert de la composante la plus grande étant obtenue directement à partir des résultats de démodulation et la fonction de transfert des autres composantes étant obtenue de façon indirecte à partir de la fonction de transfert de la composante la plus grande.

Selon une variante avantageuse on vérifiera que les signaux conduisant au calcul de chaque fonction de transfert en fonction de la fréquence, présente des niveaux de rapport signal sur bruit acceptables. En pratique le niveau du rapport signal sur bruit sera acceptable si le niveau du signal est supérieur à un seuil prédéterminé. En conséquence si le niveau est supérieur à ce seuil on prendra la fonction de transfert calculée de façon directe pour cette fréquence. Par contre si le niveau de l'un des signaux est inférieur à ce seuil, alors on remplacera la fonction de transfert obtenue directement à cette fréquence par une fonction de transfert obtenue de façon indirecte, c'est à dire calculée à partir d'une fonction de transfert obtenue de façon directe pour une autre fréquence, de préférence la fréquence correspondant à la composante continue de plus forte valeur.

Il a été vu plus haut dans un exemple relatif à un filtre passe bas du premier ordre, que les fluctuations des fonctions de transfert sont proportionnelles à celles de la bande passante du capteur scalaire hélium, le facteur de proportionnalité dépendant de $F^2$. Il est donc possible de calculer une fonction de transfert à une seconde fréquence si l'on connaît une fonction de transfert pour une première fréquence de modulation.

Un exemple d'un tel calcul est donné par la formule (4) au bas de la page 6 ci avant.

Il convient de noter que les fréquences de coupure des fonctions de transfert se situent entre 200 et 1.000 hertz et en général autour de 400 hertz alors que les fréquences des champs de superposition sont choisies entre 5 et 60 hertz en sorte que les valeurs de ces fréquences sont toujours petites par rapport aux fréquences de coupure. Il en résulte que l'on peut simplifier les calculs comme indiqué plus haut, pages 5 à 7, en particulier en faisant des développements limités par exemple au premier ordre. Egalement comme noté immédiatement ci-dessus les fonctions de transfert aux différentes fréquences de modulation peuvent se calculer à partir de l'une d'entre elles. C'est pourquoi, lorsque les données de démodulation à une fréquence sont bruitées, on aura intérêt à calculer une fonction de transfert pour cette fréquence bruitée à partir d'une fonction de transfert obtenue pour une fréquence différente dans laquelle le rapport signal sur bruit est élevé.

Enfin on appliquera aux enroulements de préférence des signaux périodiques sinusoïdaux.

**Brève description des dessins.**

La figure 1 déjà commentée comprend les parties A et B. La figure 1 partie A, représente deux courbes. Une première courbe repérée a représente l'évolution dans le temps de la valeur du module d'un vecteur champ magnétique. Une seconde courbe repérée b représente l'évolution dans le même temps de la valeur de ce module calculée à partir de ses trois composantes. La partie B représente l'évolution dans le temps de la valeur de la différence dB entre les valeurs des deux modules représentées en partie A.

La figure 2 déjà commentée représente pour les mêmes instants que les courbes représentées en figure 1 les courbes d'évolution dans le temps de la valeur de la phase de deux fonctions de transfert correspondant à deux fréquences de superposition.

La figure 3 illustre un mode de réalisation d'un dispositif conforme à l'invention.

## Description d'un mode particulier de réalisation

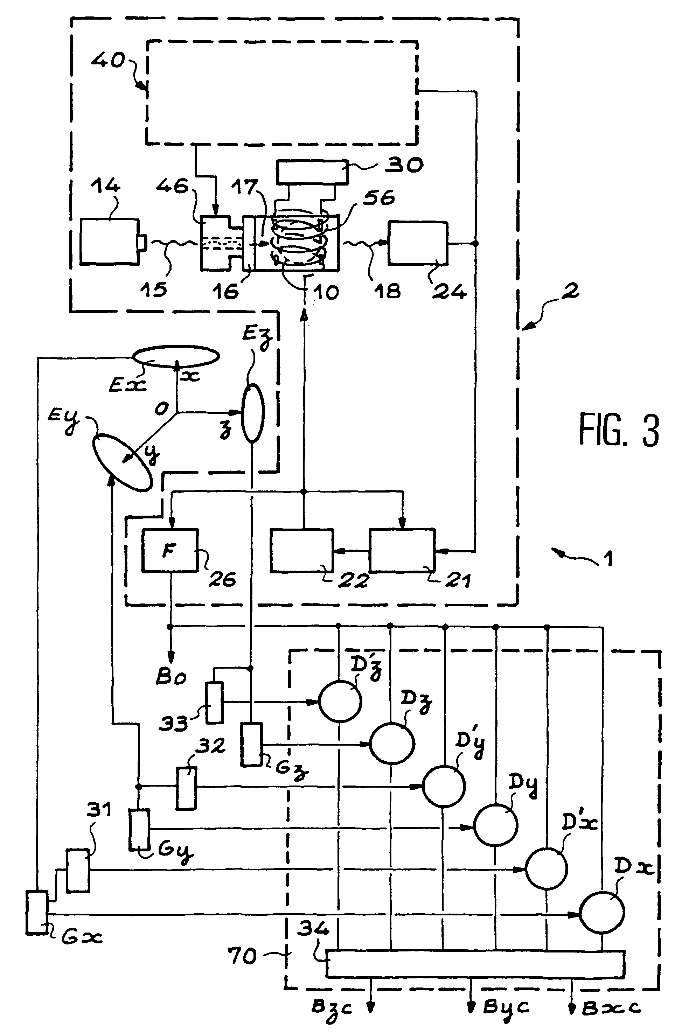

On voit, d'abord, sur la figure 3, un magnétomètre 2 scalaire à pompage optique à hélium conforme au document FR-A-2 713 347 déjà cité (ou son correspondant américain US-A-5,534,776).

Ce magnétomètre 2 comprend de façon connue une cellule 10 remplie d'hélium, un laser 14 émettant un faisceau 15, un polariseur 16 délivrant un faisceau polarisé rectiligne 17, un photodétecteur 24 recevant le faisceau 18 ayant traversé la cellule 10, un circuit d'asservissement de fréquence 21, un générateur de radiofréquence 22, un fréquencemètre 26 et un circuit de décharge 30. Le générateur 22 alimente en courant une bobine 56 placée à proximité de la cellule 10 de façon à engendrer dans cette dernière un champ de radiofréquence. La bobine 56 et le polariseur 16 sont solidarisés mécaniquement, de telle façon que toute rotation appliquée au polariseur entraîne une rotation du même angle de la direction du champ, l'intensité de ce dernier étant définie par le générateur 22.

Avantageusement, pour relier les moyens 56 et 16, on utilise un contact tournant, par exemple un contact par couplage capacitif ou par un transformateur dont l'enroulement primaire est fixe et l'enroulement secondaire mobile.

De préférence, la bobine 10 et le polariseur 16 sont montés de façon à ce que la polarisation et le champ appliqué soient parallèles.

Le circuit 40 est un circuit d'asservissement qui commande un moteur 46 réglant la position angulaire du polariseur 16. Ce circuit est décrit dans le document cité.

Dans le mode de réalisation illustré, le dispositif comprend trois enroulements conducteurs Ex, Ey et Ez dont les axes forment un trièdre en principe trirectangle Oxyz. Pour plus de clarté, ces enroulements sont représentés écartés de la cellule 10 mais, il faut comprendre que ces enroulements entourent la cellule 10. Chacun des enroulements Ex, Ey, Ez est relié à un générateur, respectivement Gx, Gy et Gz, réglés chacun sur une fréquence de modulation $F_x$, $F_y$, $F_z$ particulière. Les fréquences de modulation $F_x$, $F_y$, $F_z$ sont bien sur différentes l'une de l'autre. Conformément à l'invention chaque générateur Gx, Gy et Gz est équipé d'un retard quart d'onde, 31, 32, 33 respectivement.

Un circuit de traitement 70 comprend six démodulateurs Dx D'x, Dy D'y, Dz D'z couplés respectivement aux générateurs Gx, Gy, Gz et aux retards quart d'onde 31, 32, 33 et recevant le signal de sortie délivré par le magnétomètre scalaire, c'est-à-dire, dans le mode de réalisation illustré, le signal délivré par le fréquencemètre 26. Ce signal est, en général, un signal numérique donnant le module Bo du champ à mesurer.

L'application d'un champ extérieur Hx appliqué le long de l'axe Ox avec une fréquence Fx modifie le module du champ à mesurer d'une quantité qui varie à la fréquence Fx. Le signal de sortie du magnétomètre scalaire, qui donne le module du champ, contient donc une composante variant à la fréquence Fx, composante représentant la projection du champ à mesurer sur l'axe Ox. La valeur de cette projection dépend en outre comme expliqué plus haut de la valeur de la fonction de transfert du magnétomètre pour cette fréquence. En démodulant en phase et en quadrature le signal de sortie du magnétomètre scalaire à la fréquence Fx, on accèdera à la valeur de cette composante et aussi à la valeur du module et de la phase de la fonction de transfert. On pourra donc calculer une valeur corrigée de la composante sur Ox. De même pour les deux autres composantes.

La partie démodulation du circuit 70 composée des circuits Dx D'x, Dy D'y et Dz D'z est classique et peut travailler soit par multiplication et démodulation, soit par transformation de Fourier rapide (FFT). Elle délivre les composantes en phase et en quadrature Bx B'x, By B'y, et Bz B'z du champ selon les trois directions Ox, Oy, Oz. Ces composantes sont reçues dans un module de calcul 34 du circuit de traitement 70. Le module 34 calcule la fonction de transfert pour chaque fréquence et corrige la valeur de la composante selon chaque axe en fonction de cette fonction de transfert pour délivrer des composantes corrigées.

Avantageusement le module de calcul 34 incorpore une fonction changement d'axes pour délivrer des valeurs de chaque composante du champ sur un trièdre orthonormé calculé selon l'une des méthode décrites dans l'article de J. M. G. MERAYO, F. PRIMDAHL ET P. BRAUER déjà cité. En général comme expliqué dans cet article un axe du trièdre orthonormé calculé est confondu avec l'un des axes des enroulements. Dans l'exemple ici décrit les paramètres des matrices de transformation sont calculés dans une phase de calibrage préalable identique dans le principe aux méthodes appliquées aux portes de flux (fluxgates en terminologie anglaise).

Lorsque les trois composantes Bx, By, Ez corrigées du champ sont celles recalculées dans le repère orthonormé calculé, elles sont reliées au module du champ Bo par la relation

$$B_x^2 + B_y^2 + B_z^2 = B_0^2.$$

On peut donc aussi n'utiliser que deux enroulements, par exemple Ex, Ey, deux générateurs Gx, Gy et deux démodulateurs Dx, Dy pour obtenir les deux composantes Bx et By et retrouver la troisième Bz à partir de la valeur continue Bo donnée par le fréquencemètre 26. La relation donnant Bz est à l'évidence :

$$\left| B_z \right| = \left[ B_0^2 - B_x^2 - B_y^2 \right]^{1/2}$$

Naturellement, le mode de réalisation qui vient d'être décrit n'est donné qu'à titre d'exemple et l'on pourrait utiliser un autre magnétomètre scalaire que le magnétomètre décrit, l'essentiel étant qu'il délivre un signal de sortie reflétant le module du champ.

Il est possible aussi de n'utiliser qu'un retard quart d'onde par exemple 31, et de calculer la fonction de transfert uniquement pour la fréquence alimentant l'enroulement $E_x$, les fonctions de transfert pour les deux autres composantes étant obtenues de façon indirecte à partir de l'unique fonction de transfert obtenue de façon directe.

Il a été vu ci-dessus que le nombre d'enroulements Ex, Ey, Ez, peut varier entre deux et trois, que le nombre de retards quart d'onde 31 32 33 peut varier entre un et trois, il en résulte que le nombre de détecteurs synchrones peut varier entre 3 et 6. Il y en aura trois si l'on a deux générateurs dont un seul équipé d'un retard, et 6 pour trois générateurs équipés chacun d'un retard.

On aura intérêt à ce que les moyens de traitement 70 comportent un nombre de moyens de détection synchrone égal ou au plus égal à la somme du nombre de générateurs de signaux et du nombre de retards quart d'onde 31-33 équipant lesdits générateurs de signaux.

(1) L'article de J. M. G. MERAYO, F. PRIMDAHL ET P. BRAUER remis le 21 janvier 2000 aux participants au premier "Workshop for calibration of the magnetic field of the earth" tenu à Saclay et intitulé "l'orthogonalisation des systèmes magnétiques" doit paraître dans la revue "sensors and actuators" (Sensors and Actuators A 89 (2001) 185-196).

**Revendications**

1. Dispositif (1) de mesure précise des composantes d'un champ magnétique ayant :

   un magnétomètre (2) scalaire délivrant un signal de sortie correspondant au module d'un champ magnétique appliqué :

   - au moins deux enroulements conducteurs (Ex, Ey, Ez) disposés autour dudit magnétomètre scalaire, ces enroulements conducteurs (Ex, Ey, Ez) ayant des axes orientés dans des directions différentes (Ox, Oy, Oz),
   - des moyens pour alimenter chaque enroulement par un courant ayant une fréquence déterminée (Fx, Fy, Fz) propre à cet enroulement,
   - des moyens de traitement (70) recevant le signal délivré par le magnétomètre (2) scalaire, et traitant ce signal pour en déduire une valeur de la composante continue selon chacun des axes des enroulements,

   dispositif **caractérisé en ce que** au moins l'un des moyens (Gx, Gy, Gz) pour alimenter chaque enroulement (Ex, Ey, Ez) par un courant ayant une fréquence déterminée (Fx, Fy, Fz) propre à cet enroulement, produit à cette fréquence des signaux en phase et en quadrature, **en ce que** les moyens de traitement (70) recevant le signal délivré par le magnétomètre (2) scalaire, comprennent des moyens de démodulation (Dx, D'x, Dy D'y, Dz D'z) aptes à effectuer outre une démodulation synchrone en phase au moins aux fréquences (Fx, Fy, Fz) d'alimentation des enroulements, une démodulation en quadrature pour au moins l'une des fréquences (Fx, Fy, Fz) des courants d'alimentation des enroulements (Ex, Ey, Ez), ces moyens de démodulation recevant outre le signal en phase généré par l'alimentation des enroulements (Ex, Ey, Ez) le signal en quadrature en provenance des moyens de génération (Gx, Gy, Gz) et enfin **en ce que** ces moyens de traitement (70) comprennent un module de calcul (34) calculant de façon directe ou indirecte à partir des résultats des différentes démodulations pour chaque fréquence, au moins une fonction de transfert du magnétomètre pour l'une des fréquences délivrées par les moyens pour alimenter chaque enroulement par un courant ayant une fréquence déterminée (Fx, Fy, Fz) propre à cet enroulement, et corrigeant la valeur du module de chaque composante par application de la fonction de transfert calculée de façon directe ou indirecte.

2. Dispositif (1) de mesure précise des composantes d'un champ magnétique selon la revendication 1 dans lequel les axes (Ox, Oy, Oz) des enroulements conducteurs (Ex, Ey, Ez) forment un repère orthonormé ou proche d'un repère orthonormé.

3. Dispositif (1) selon la revendication 2, comprenant trois enroulements conducteurs (Ex, Ey, Ez) à axes mutuellement orthogonaux (Ox, Oy, Oz).

4. Dispositif (1) selon l'une des revendications 1 à 3 dans lequel des moyens de génération (Gx, Gy, Gz) pour alimenter chaque enroulement (Ex, Ey, Ez) par un courant ayant une fréquence déterminée (Fx, Fy, Fz) propre à cet enroulement sont équipés d'un retard quart d'onde (31-33) dont une sortie est couplée à un moyen de détection ($D'_x$, $D'_y$, $D'_z$).

5. Dispositif (1) selon l'une des revendications 1 à 4 dans lequel les moyens de traitement (70) comportent un nombre de moyens de détection synchrone égal à la somme du nombre de générateurs de signaux et du nombre de retards quart d'onde (31-33) équipant lesdits générateurs de signaux

6. Procédé de mesure de composantes d'un champ magnétique selon des axes (Ox, Oy, Oz), orientés dans des directions différentes, obtenues à partir d'un dispositif utilisant un magnétomètre scalaire délivrant un signal de sortie correspondant au module $B_0$ d'un champ magnétique appliqué, le procédé consistant à superposer au champ magnétique à mesurer des champs orientés chacun selon chacun des axes (Ox, Oy, Oz) respectivement, ces champs variant dans le temps de façon périodique selon une fréquence (Fx, Fy, Fz) spécifique à chaque axe, puis à démoduler de façon synchrone à chacune des fréquences (Fx, Fy, Fz) le signal issu du magnétomètre et à traiter le signal résultant d'une démodulation synchrone à une fréquence pour en déduire la valeur de la composante continue du champ magnétique selon l'axe recevant le champ superposé à cette fréquence, procédé **caractérisé en ce que** pour l'une au moins des directions axiales, la démodulation est effectuée de façon synchrone en phase et en quadrature pour l'un au moins des champs superposés et **en ce que** on calcule directement à partir des résultats de démodulation au moins une fonction de transfert du magnétomètre pour l'une des fréquences à laquelle on a effectué une superposition d'un champ périodique à cette fréquence, et éventuellement de façon indirecte une ou deux fonctions de transfert à partir d'une fonction de transfert obtenue directement et **en ce que** l'on corrige la valeur du module de chaque composante par application de l'une des fonctions de transfert calculées de façon directe ou indirecte.

7. Procédé de mesure de composantes d'un champ magnétique selon la revendication 6 dans lequel on calcule directement à partir des résultats de la démodulation en phase et en quadrature une fonction de transfert par fréquence de modulation et dans lequel on applique la fonction de transfert calculée pour chacune des fréquences de modulation respectivement à la correction de la composante du champ magnétique correspondant à cette fréquence de modulation.

8. Procédé de mesure de composantes d'un champ magnétique selon la revendication 6 dans lequel :

   - on calcule les composantes non corrigées du champ magnétique,
   - on effectue une comparaison entre les composantes pour déterminer la plus grande,
   - on effectue la correction en appliquant à chaque composante axiale la fonction de transfert correspondant à la fréquence de modulation appliquée à l'enroulement selon l'axe de cette composante axiale, la fonction de transfert de la composante la plus grande étant obtenue directement à partir des résultats de démodulation et la fonction de transfert des autres composantes étant obtenue de façon indirecte à partir de la fonction de transfert de la composante la plus grande.

9. Procédé de mesure de composantes d'un champ magnétique selon la revendication 6 dans lequel :

   - on calcule les composantes non corrigées du champ magnétique,
   - on compare la valeur de chacune des composantes à une valeur seuil
   - on effectue une comparaison entre les composantes pour déterminer la plus grande,
   - ensuite on corrige chacune des composantes supérieures au seuil en lui appliquant la fonction de transfert correspondant à la fréquence relative à cette composante obtenue de façon directe, et on corrige les composantes inférieures au seuil en leur appliquant une fonction de transfert obtenue de façon indirecte à partir de la fonction de transfert correspondant à la plus grande des composantes.

10. Procédé de mesure de composantes d'un champ magnétique selon l'une des revendications 6 à 9 dans lequel on recalcule les composantes du champ magnétique à partir des composantes axiales corrigées dans un système d'axes fictifs exactement orthonormé, l'un des axes fictifs coïncidant avec l'un des axes des enroulements.

**Patentansprüche**

1. Vorrichtung (1) zur genauen Messung der Komponenten eines Magnetfelds mit:

   einem skalaren Magnetometer (2), ein dem Modul eines angewendeten Magnetfeld entsprechendes Signal liefernd:

   - wenigstens zwei um das skalare Magnetometer herum angeordnete leitfähige Wicklungen (Ex, Ey, Ez), wobei diese Wicklungen (Ex, Ey, Ez) Achsen mit unterschiedlichen Richtungen (Ox, Oy, Oz) haben,
   - Einrichtungen zur Versorgung jeder Wicklung mit einem Strom mit einer bestimmten, für diese Wicklung charakteristischen Frequenz (Fx, Fy, Fz),
   - Verarbeitungseinrichtungen (70), die das durch das skalare Magnetometer gelieferte Signal empfangen und dieses Signal verarbeiten, um daraus für jede der Achsen der Wicklungen einen Wert des Gleichanteils bzw. der Gleichstromkomponente abzuleiten,

   **dadurch gekennzeichnet, dass** wenigstens eine der Einrichtungen (Gx, Gy, Gz) zur Versorgung jeder Wicklung (Ex, Ey, Ez) mit einem Strom mit einer bestimmten, für diese Wicklung charakteristischen Frequenz (Fx, Fy, Fz) in dieser Frequenz gleichphasige und um 90° phasenverschobene Signale erzeugt, und **dadurch**, dass die das durch das skalare Magnetometer (2) gelieferte Signal empfangenden Verarbeitungseinrichtungen (70) Demodulationseinrichtungen (Dx, D'x, Dy, D'y, Dz, D'z) umfassen, fähig außer einer phasensynchronen Demodulation mit wenigstens den Versorgungsfrequenzen (Fx, Fy, Fz) der Wicklungen eine um 90° phasenverschobene Demodulation für wenigstens eine der Frequenzen (Fx, Fy, Fz) der Versorgungsströme der Wicklungen (Ex, Ey, Ez) durchzuführen, wobei diese Demodulationseinrichtungen außer dem durch die Versorgung der Wicklungen (Ex, Ey, Ez) erzeugten gleichphasigen Signal das von den Erzeugungseinrichtungen (Gx, Gy, Gz) stammende, um 90° phasenverschobene Signal erhalten, und schließlich **dadurch**, dass die Verarbeitungseinrichtungen (70) einen Rechenmodul (34) umfassen, der direkt oder indirekt aufgrund der Resultate der verschiedenen Demodulationen für jede Frequenz wenigstens eine Transferfunktion des Magnetometers für eine der Frequenzen berechnet, die durch die Einrichtungen zur Versorgung jeder Wicklung mit einem Strom mit einer bestimmten, für diese Wicklung charakteristischen Frequenz (Fx, Fy, Fz) geliefert werden, und den Wert des Moduls jeder Komponente durch Anwendung der direkt oder indirekt berechneten Transferfunktion korrigiert.

2. Vorrichtung (1) zur genauen Messung der Komponenten eines Magnetfelds nach Anspruch 1, bei der die Achsen (Ox, Oy, Oz) der leitfähigen Wicklungen (Ex, Ey, Ez) ein orthonormiertes Bezugssystem oder ein im Wesentlichen orthonormiertes Bezugssystem bilden.

3. Vorrichtung (1) nach Anspruch 2, drei leitfähige Wicklungen (Ex, Ey, Ez) mit gegenseitig orthogonalen Achsen (Ox, Oy, Oz) umfassend.

4. Vorrichtung (1) nach einem der Ansprüche 1 bis 3, bei der die Erzeugungseinrichtungen (Gx, Gy, Gz) zur Versorgung jeder Wicklung (Ex, Ey, Ez) mit einem Strom mit einer bestimmten, für diese Wicklung charakteristischen Frequenz (Fx, Fy, Fz) mit einer Viertelwellen-Verzögerung (31-33) ausgerüstet sind, von der ein Ausgang mit einer Detektionseinrichtung ($D'_x$, $D'_y$, $D'_z$) gekoppelt ist.

5. Vorrichtung (1) nach einem der Ansprüche 1 bis 4, bei der die Verarbeitungseinrichtungen (70) eine Anzahl Synchrondetektionseinrichtungen gleich der Summe der Anzahl Signalgeneratoren und der Anzahl Viertelwellen-Verzögerungen (31-33) umfassen, mit denen die genannten Signalgeneratoren ausgerüstet sind.

6. Verfahren zur Messung von Komponenten eines Magnetfelds gemäß Achsen (Ox, Oy, Oz) mit unterschiedlichen Ausrichtungen, realisiert mittels einer Vorrichtung, die ein skalares Magnetometer benutzt, das ein Ausgangssignal liefert, welches dem Modul $B_0$ eines angewandten Magnetfelds entspricht, wobei das Verfahren darin besteht, dem zu messenden Magnetfeld Felder zu überlagem, von denen jedes jeweils gemäß jeder der Achsen (Ox, Oy, Oz) ausgerichtet ist, wobei diese Felder zeitlich in periodischer Weise gemäß einer für jede Achse spezifischen Frequenz (Fx, Fy, Fz) variieren, dann in synchroner Weise mit jeder der Frequenzen (Fx, Fy, Fz) das von dem Magnetometer stammende Signal zu demodulieren, und das aus einer synchronen Demodulation resultierende Signal mit einer Frequenz zu verarbeiten, um daraus den Wert der Gleichstromkomponente bzw. des Gleichanteils des Magnetfelds in der Achse abzuleiten, die das mit dieser Frequenz überlagerte Feld erhält, wobei das Verfahren **dadurch gekennzeichnet ist, dass** für wenigstens eine der axialen Richtungen die Demodulation für wenigstens eines der überlagerten Felder in synchroner Weise gleichphasig oder um 90° phasenverschoben erfolgt, und **dadurch**, dass man aufgrund der Demodulationsresultate wenigstens eine Transferfunktion des Magnetometers für eine der Frequenzen, bei der man eine Überlagerung eines bei dieser Frequenz periodischen Felds durchgeführt hat, direkt berechnet, und eventuell eine oder zwei Transferfunktionen aufgrund einer direkt erhaltenen Transferfunktion auf indirekte Weise berechnet, und **dadurch**, dass man den Wert des Moduls von jeder Komponente durch Anwendung von einer der direkt oder indirekt berechneten Transferfunktionen korrigiert.

**7.** Verfahren zur Messung von Komponenten eines Magnetfelds nach Anspruch 6, bei dem man aufgrund der Resultate der gleichphasigen und um 90° phasenverschobenen Demodulation eine Transferfunktion durch Frequenzmodulation direkt berechnet, und bei dem man die für jede der Modulationsfrequenzen berechnete Transferfunktion bei der Korrektur der Komponente des dieser Modulationsfrequenz entsprechenden Magnetfelds anwendet.

**8.** Verfahren zur Messung von Komponenten eines Magnetfelds nach Anspruch 6, bei dem:

- man die nicht-korrigierten Komponenten des Magnetfelds berechnet,
- man einen Vergleich zwischen den Komponenten durchführt, um die größte zu bestimmen,
- man die Korrektur durchführt, indem man bei jeder Axialkomponente die Transferfunktion anwendet, die der bei der Wicklung gemäß der Achse dieser Axialkomponente angewandten Modulationsfrequenz entspricht, wobei man die Transferfunktion der größten Komponente direkt erhält aufgrund der Demodulationsresultate, und man die Transferfunktion der anderen Komponenten indirekt erhält aufgrund der Demodulationsresultate der größten Komponente.

**9.** Verfahren zur Messung von Komponenten eines Magnetfelds nach Anspruch 6, bei dem:

- man die nicht-korrigierten Komponenten des Magnetfelds berechnet,
- man den Wert von jeder Komponente mit einem Schwellenwert vergleicht,
- man einen Vergleich zwischen den Komponenten durchführt, um die größte zu bestimmen,
- man anschließend jede der einen Schwellenwert überschreitenden Komponenten korrigiert, indem man bei ihr die direkt erlangte Transferfunktion anwendet, der diese Komponente betreffenden Frequenz entsprechend, und man die Komponenten, die kleiner sind als der Schwellenwert, korrigiert, indem man bei ihnen eine Transferfunktion anwendet, die man auf indirekte Weise aufgrund der Transferfunktion erlangt, die der größten Komponente entspricht.

**10.** Verfahren zur Messung von Komponenten eines Magnetfelds nach einem der Ansprüche 6 bis 9, bei dem man die Komponenten des Magnetfelds neu berechnet aufgrund der in einem System mit exakt orthonormierten fiktiven Achsen korrigierten Axialkomponenten, wobei eine der fiktiven Achsen mit einer der Achsen der Wicklungen zusammenfällt.

## Claims

**1.** Precision device (1) for measuring the components of the magnetic field comprising:

a scalar magnetometer (2) supplying an output signal corresponding to the module of an applied magnetic field:

- at least two conductor coils (Ex, Ey, Ez) positioned around the said scalar magnetometer, the axes of these conductor coils (Ex, Ey, Ez) being orientated in different directions (Ox, Oy, Oz),
- means for powering each coil with a current with a determined frequency (Fx, Fy, Fz) specific to this coil,
- processing means (70) that receive the signal provided by the scalar magnetometer (2), and processing this signal to deduce the value of the continuous component along each of the axes of the coils,
- device **characterized in that** at least one of the means (Gx, Gy, Gz) that power coil (Ex, Ey, Ez) with a current of a determined frequency (Fx, Fy, Fz) specific to each coil, produce at this frequency signals in phase and in quadrature, **in that** the processing means (70) which receive the signal provided by the scalar magnetometer (2) are capable of carrying out, apart from a synchronous demodulation in phase at least at the frequencies (Fx, Fy, Fz) powering the coils, a demodulation in quadrature for at least one of the frequencies (Fx, Fy, Fz) of the currents powering the coils (Ex, Ey, Ez), these demodulation means receiving, apart from the signal in phase generated by the power supply of the coils (Ex, Ey, Ez), the signal in quadrature from the generation means (Gx, Gy, Gz) and finally **in that** these processing means (70) include a calculation module (34) directly or indirectly calculating on the basis of the results of the different demodulations for each frequency, at least one transfer function of the magnetometer for one of the frequencies supplied by the means for supplying each coil with a current having a given frequency (Fx, Fy, Fz) specific to said coil, and correcting the value of the module of each component by applying the directly or indirectly calculated transfer function.

2.  Precision device (1) for measuring the components of the magnetic field of claim 1, in which the axes (Ox, Oy, Oz) of the conductor coils (Ex, Ey, Ez) form an orthonormal reference or close to an orthonormal reference.

3.  Device (1) of claim 2, comprising three conductor coils (Ex, Ey, Ez) at mutually orthogonal axes (Ox, Oy, Oz).

4.  Device (1) of any of claims 1 to 3 in which the generation means (Gx, Gy, Gz) that power each coil (Ex, Ey, Ez) with a current of a determined frequency (Fx, Fy, Fz) specific to this coil are equipped with a quarter wave delay (31-33) whose output is coupled to a detection means (D'x, D'y, D'z).

5.  Device (1) of any of claims 1 to 4 in which the processing means (70) have a number of synchronous detection means equal to the total number of signal generators and the number of quarter wave delays (31-33) equipping the said signal generators.

6.  Process for measuring the components of a magnetic field along the axes (Ox, Oy, Oz), orientated in different directions, obtained using a device using a scalar magnetometer providing an output signal corresponding to the module Bo of an applied magnetic field, the process consisting of superposing on the magnetic field to be measured, fields that are each orientated along each of the axes (Ox, Oy, Oz) respectively, these superposed fields varying in time periodically according to a frequency (Fx, Fy, Fz) that is specific to each axis, and then synchronously demodulating at each of the frequencies (Fx, Fy, Fz) the signal emitted from the scalar magnetometer and processing the signal resulting from a synchronous demodulation at one frequency, in order to deduce the value of the continuous component of the magnetic field along the axis receiving the superposed field at this frequency, a process **characterized in that** for at least one of the axial directions, the demodulation is carried out synchronously in phase and in quadrature for at least one of the superposed fields, and **in that** from the demodulation results at least one transfer function of the magnetometer is directly calculated for one of the frequencies at which a periodic field was superposed at this frequency, and possibly indirectly one or two transfer functions from a transfer function obtained directly and **in that** the value of the module of each component is corrected by application of one of the transfer functions calculated directly or indirectly.

7.  Process for measuring the components of a magnetic field of claim 6 in which, based on the demodulation results in phase and in quadrature, a transfer function per modulation frequency is calculated directly and in which the calculated transfer function is applied for each of the modulation frequencies respectively for the correction of the component of the magnetic field corresponding to this modulation frequency.

8.  Process for measuring the components of a magnetic field of claim 6 in which:

    -   the uncorrected components of the magnetic field are calculated;
    -   a comparison is made of the components to determine which is the largest;
    -   the correction is made by applying to each axial component the transfer function corresponding to the frequency modulation applied to the coil along the axis of this axial component, the transfer function of the largest component being obtained directly from the demodulation results, and the transfer function of the other components being obtained indirectly from the transfer function of the largest component.

9.  Process for measuring the components of a magnetic field of claim 6 in which:

    -   the uncorrected components of the magnetic field are calculated,
    -   the value of each of the components is compared to a threshold value;
    -   a comparison is made of the components to determine which is the largest;
    -   the correction is then made to each of the components above the threshold by applying the transfer function corresponding to the frequency relative to this component, obtained directly, and the components below the threshold are corrected by applying a transfer function obtained indirectly from the transfer function of the largest component.

**10.** Process for measuring the components of a magnetic field of any of claim 6 to 9 in which the components of the magnetic field are recalculated based on axial components corrected in a fictitious, exactly orthonormal axis system, one of the fictitious axes coinciding with one of the coil axes.

FIG. 1

FIG. 2

FIG. 3